# EUROPEAN PATENT APPLICATION

(11) **EP 2 151 774 A1**
(43) Date of publication of application: **10.02.2010**
(21) Application number: 08751739.7
(22) Date of filing: 16.05.2008
(51) Int. Cl.: G06F 17/50

(54) **LIBRARY FOR ELECTRIC CIRCUIT SIMULATION, RECORDING MEDIUM STORING IT, AND LIBRARY GENERATION SYSTEM**

(30) Priority: 22.05.2007 JP 2007135144
(71) Applicant: Panasonic Corporation, Kadoma-shi Osaka 571-8501 (JP)
(72) Inventor: SASAKI, Yukinori, Osaka 540-6207 (JP)
(74) Representative: Grünecker, Kinkeldey, Stockmair & Schwanhäusser Anwaltssozietät
(86) International application number: PCT/JP2008/001221
(87) International publication number: WO 2008/142856

(57) **Abstract**

A library for electronic circuit simulation stores information on electrical characteristics and information on the 3D shape of a flexible substrate. The electrical characteristics of the flexible substrate change in response to changes in the 3D shape. Accordingly, there is no need to execute electromagnetic simulation every time the shape of flexible substrate is changed. This improves the design efficiency.

## Description

### TECHNICAL FIELD

The present invention relates to libraries for simulating electronic circuits employing flexible substrates, recording media storing these libraries, and library generating systems..

### BACKGROUND ART

In line with increasing downsizing and thinning of electronic devices, a flexible substrate is increasingly used for a printed circuit board inside an electronic device. To shorten a period for designing electronic devices employing printed circuit boards including flexible substrates, diversifying simulation systems have been used. In transmission line simulation used typically for noise reduction, a simulation program for electronic circuits called SPICE (Simulation Program with Integrated Circuit Emphasis) developed at the University of California, Berkeley has often been used in the past. However, in line with the increasing use of higher frequencies in electronic devices, it is becoming difficult to express electrical characteristics of printed circuit board by lumped parameter elements, such as capacitors and resistances. Therefore, the use of electromagnetic simulation is also increasing. For example, Patent Literature 1 discloses transmission line simulation of an electronic device including a printed circuit board and electronic component. This simulation combines an equivalent circuit model retaining electrical characteristics of electronic component or connector extracted from a component library and an equivalent circuit model for wiring of printed circuit board obtained by electromagnetic simulation.

Since a flexible substrate takes any 3D shape, an optimal shape of flexible substrate is not yet known at an initial design stage. Its shape cannot thus be determined. Accordingly, it is impossible to prepare an equivalent circuit model for flexible substrate using a component library in which the shape is fixed, as disclosed in Patent Literature 1. In addition, the electromagnetic simulation for calculating an equivalent circuit model for wiring of printed circuit board, which is disclosed in Patent Literature 1, executes simulation on the condition that wiring of the printed circuit board is uniformly formed in a vertical direction with respect to its cross-section. Therefore, this simulation is not applicable to simulation of a flexible substrate, which may take a complicated shape such as a shape twisted for one turn.

Patent Literature: Japanese Patent Unexamined Publication No. H9-274623.

### SUMMARY OF THE INVENTION

The present invention enables simulation of electronic circuit employing a flexible substrate.

A library for electronic circuit simulation of the present invention stores information on electrical characteristics and 3D shapes of a flexible substrate, and these electrical characteristics change in response to changes in the 3D shape.

Based on this library, electrical characteristics of flexible substrate change in response to changes in the 3D shape of flexible substrate. Therefore, characteristics of an electronic device employing flexible substrate can be more accurately simulated even if the shape of flexible substrate is frequently changed. In addition, there is no need to execute electromagnetic simulation every time the 3D shape of flexible substrate is changed. This is particularly suitable for the initial design stage that requires shorter simulation time as much as possible due to a continuing process of trials and errors.

### BRIEF DESCRIPTION OF DRAWINGS

Fig. 1 is a perspective view of an electronic device employing a flexible substrate in accordance with a first exemplary embodiment of the present invention.
Fig. 2 is a block diagram of electronic circuit simulation in accordance with the first exemplary embodiment of the present invention.
Fig. 3 is a perspective view of a flexible substrate for describing characteristic dimensions of a 3D shape of flexible substrate in accordance with the first exemplary embodiment of the present invention.
Fig. 4 is an equivalent circuit model retaining electrical characteristics of the flexible substrate in accordance with the first exemplary embodiment of the present invention.
Fig. 5 is a library generating system for flexible substrate in accordance with a second exemplary embodiment of the present invention.
Fig. 6 is another library generating system for flexible substrate in accordance with the second exemplary embodiment of the present invention.

### REFERENCE MARKS IN THE DRAWINGS

- 1, 2: Printed circuit board
- 3: Flexible substrate
- 4: Surface-mount electronic component
- 5: Electric wiring
- 6: Connector
- 7: Input unit
- 8: Display unit
- 9: Dimension extractor
- 10: Recording medium
- 11: Characteristic calculator
- 12: Electrical characteristic display unit
- 13: Circuit diagram generator
- 14: Mechanical characteristic display unit

### DETAILED DESCRIPTION OF PREFERRED EMBODIMENTS

Exemplary embodiments of the present invention are described below with reference to drawings.

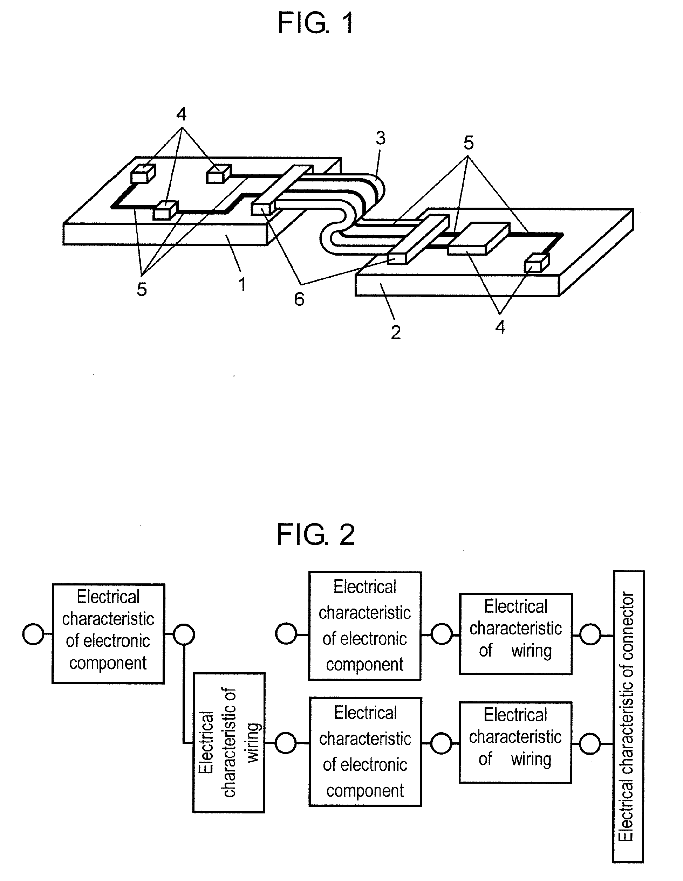

### (FIRST EXEMPLARY EMBODIMENT)The first exemplary embodiment of the present invention is described below with reference to Figs. 1 to 4.

Fig. 1 is a perspective view of an electronic device employing a flexible substrate in the first exemplary embodiment of the present invention. In Fig. 1, flexible substrate 3 is connected to rigid printed circuit board 1 and rigid printed circuit board 2 by connectors 6. Surface-mount electronic components 4 are placed on printed circuit boards 1 and 2, and are connected to each other by electrical wiring 5.

For selecting electronic components, determining circuit configuration, and designing wiring on a printed circuit board in the electronic device, computer-aided electronic circuit simulation is often used. To execute this electronic circuit simulation, a designer selects electrical characteristics of candidate electronic components and connectors that may be used in the electronic device, and also selects electrical characteristics of electrical wiring of the printed circuit board from a library prepared in advance for simulation. Then, an electronic circuit simulator combines these selected items and prepares a circuit diagram for simulation so as to determine whether or not these electrical characteristics fulfill target characteristics.

Fig. 2 is a block diagram of the electronic circuit simulation in the first exemplary embodiment of the present invention. More specifically, this is a block diagram including printed circuit board 1 in Fig. 1.

The electrical characteristics of electrical wiring of the printed circuit board are normally calculated based on electrical material characteristics of printed circuit board, such as relative permittivity and dielectric loss; and 3D shape information, which is physical dimensions including the thickness of printed circuit board and the length, width, and thickness of electrical wiring. Electrical wiring of the foregoing rigid printed circuit board rarely takes an arbitrary shape, based on rules for manufacturing printed circuit boards. Electrical wiring patterns can thus be categorized into several limited types. Accordingly, by preparing a library for electrical characteristics of these categorized electrical wirings of printed circuit boards, a designer can easily reuse the library for electronic circuit simulation. This increases the design efficiency.

However, electrical characteristics of electrical wirings of these rigid printed circuit boards are calculated on the condition that a 2D cross-section of a printed circuit board is uniform in a longer direction of electrical wiring. Therefore, this is not applicable to electrical wiring of a flexible substrate that may take any 3D shape. Even if electromagnetic simulation is applied to the entire flexible substrate so as to obtain electrical characteristics and they are used for electronic circuit simulation, it will take more than a few days for calculation if electromagnetic simulation such as a finite element method or finite-difference time-domain method is used. This is because a flexible substrate, in general, has a relatively large area compared to its thickness. Accordingly, these methods are not suitable at the initial design stage when the shape of flexible substrate is not yet determined.

Therefore, in the present invention, electrical characteristics of electrical wiring of flexible substrates are linked to 3D shape information in advance in a library. This increases the simulation efficiency at the initial design a stage of electronic devices, and leads to higher design efficiency.

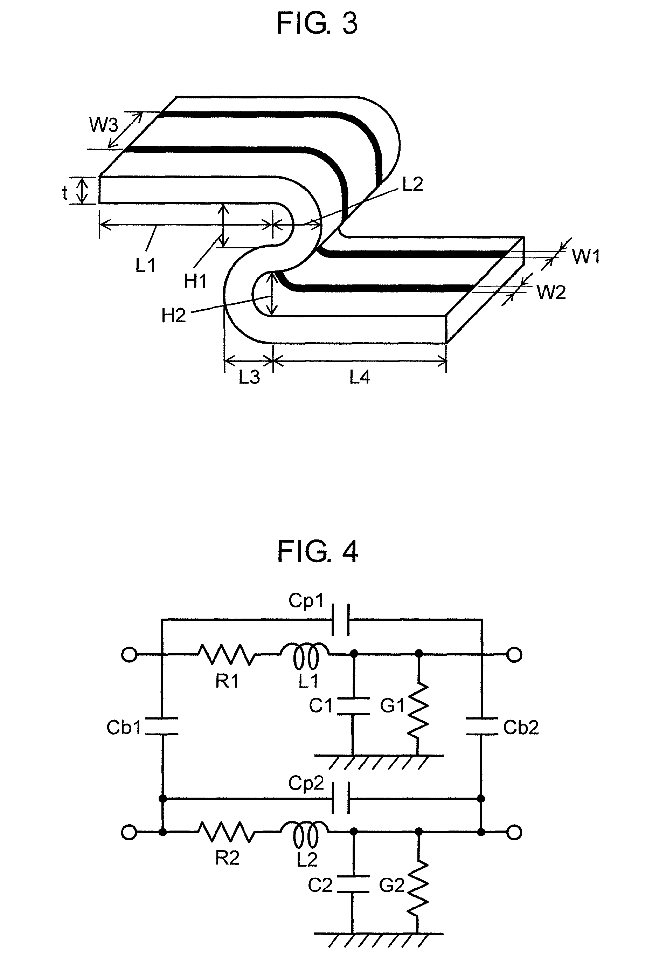

Fig. 3 is a perspective view of a flexible substrate with characteristic 3D dimensions in the first exemplary embodiment of the present invention. Fig. 4 is an equivalent circuit model retaining electrical characteristics of the flexible substrate in Fig. 3. In Figs. 3 and 4, R1 and R2 stand for resistance, L 1 and L2 stand for inductance, G1 and G2 stand for conductance, and C1, C2, Cp1, Cp2, Cb1, and Cb2 stand for capacitance expressed by lumped parameters, respectively. These lumped parameters are functions that include variables such as wiring length L1, wiring interval W3, and relative permittivity of flexible substrate material shown in Fig. 3. Accordingly, a designer can obtain an equivalent circuit model instantaneously by inputting design information on flexible substrate, such as characteristic dimensions shown in Fig. 3. Then, by combining this equivalent circuit model for flexible substrate and aforementioned electrical characteristics of electronic components and connectors, and using a circuit diagram for entire electronic device; electronic circuit simulation for predicting characteristics of the entire electronic device becomes feasible.

If electrical characteristics of electrical wiring of flexible substrate cannot be expressed by the equivalent circuit model using lumped parameters, as shown in Fig. 4, electrical characteristics are expressed by S-parameters. As long as S-parameter values at sampling frequencies are aforementioned functions of design information on flexible substrate, electrical characteristics of electrical wiring of flexible substrate for executing electronic circuit simulation can be obtained instantaneously in the same way.

This library retaining electrical characteristics, such as equivalent circuit model and S parameters, is often used in a general-purpose commercial electronic circuit simulator. Therefore, libraries are preferably prepared in a basic format. For example, in case of equivalent circuit models, SPICE format or EDIF format (Electronic Design Interchange Format) is preferably adopted.

### (SECOND EXEMPLARY EMBODIMENT)

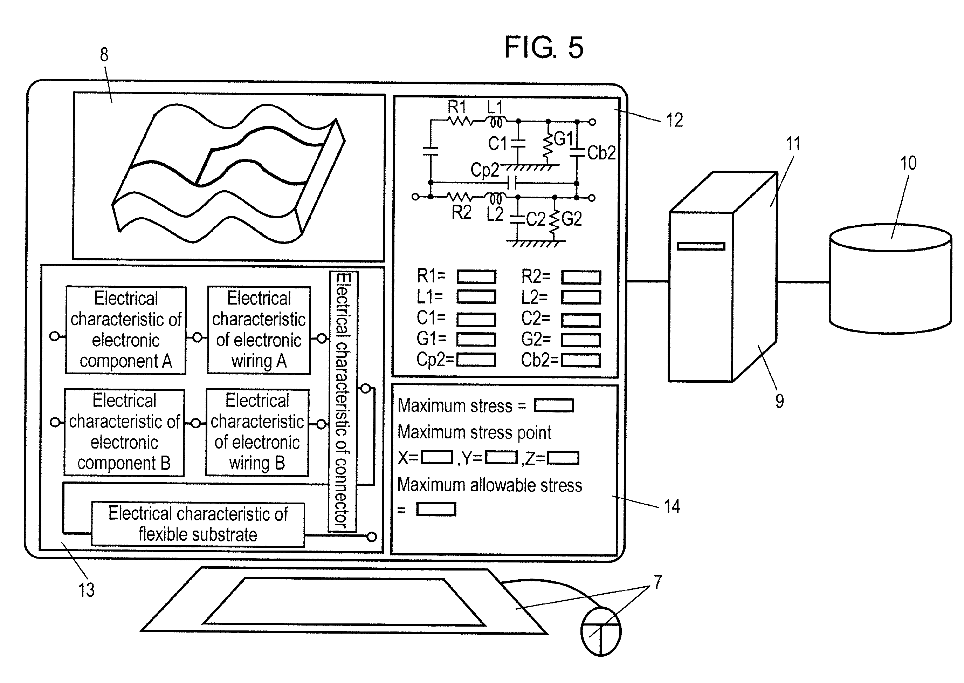

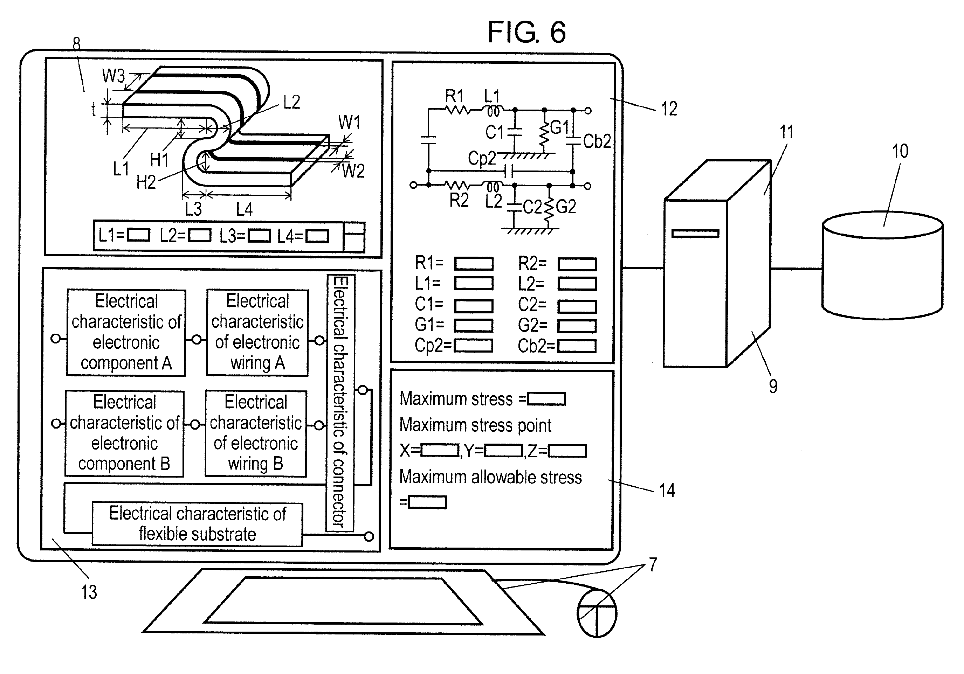

The second exemplary embodiment of the present invention is described below with reference to Figs. 5 and 6.

Fig. 5 illustrates a library generating system for flexible substrates in the second exemplary embodiment of the present invention. In Fig. 5, input unit 7, such as keyboard and mouse, is used for drawing a 3D shape of the flexible substrate. Display unit 8 visually displays a 3D schematic view of flexible substrate. Dimension extractor 9 determines the 3D shape including substrate thickness, electrical wiring length, and bending dimension based on the 3D shape of the input flexible substrate, and calculates characteristic dimensions to extract. Recording medium 10 stores a library of flexible substrates. Characteristic calculator 11 searches from the library electrical characteristics of a flexible substrate that has a 3D shape closest to the 3D shape of flexible substrate extracted by dimension extractor 9. Display unit 12 displays an equivalent circuit model retaining the electrical characteristics of flexible substrate searched by characteristic calculator 11. Circuit diagram generator 13 combines the electrical characteristics of electronic components, connectors, and flexible substrate, and prepares a circuit diagram for simulation of the entire electronic device. Mechanical characteristic display unit 14 displays mechanical characteristics calculated based on the 3D shape information of flexible substrate and substrate material information.

Unlike normal printed circuit boards, flexible substrates can be bent or twisted, and thus flexible substrates can have any 3D shape. Accordingly, a display unit is extremely useful for visually confirming the 3D shape so as to determine whether or not an intended design is fulfilled. In the design concept stage at which the thickness, length, and width of flexible substrate are not determined yet, i.e., the initial design stage, the shape of flexible substrate is ideally examined based on designer's free-minded ideas. On the other hand, it is troublesome to manually extract characteristic dimensions of the 3D shape, such as thickness, width, and length of the substrate and bending radius of a bending portion; after the shape of flexible substrate is freely determined. This is not suitable in the design concept stage where the shape is repeatedly changed and characteristics need to be confirmed every time.

Therefore, aforementioned troublesome work can be eliminated and the design efficiency can be drastically increased by using a computer to automatically calculate and extract characteristic 3D dimensions for determining electrical characteristics based on the 3D shape of a flexible substrate prepared.

Next, extracted 3D shape dimensions are compared with that of existing flexible substrates in a library stored in a database, and data closest to conditions of the flexible substrate prepared is used for electronic circuit simulation. Electrical characteristics of the selected flexible substrate are linked to electrical characteristics of a connector to which the flexible substrate is connected, a rigid printed circuit board to which the connector is connected, and a surface-mount electronic component. In this way a circuit diagram for simulating the entire electronic device is prepared.

Fig. 6 illustrates another library generating system for flexible substrates in the second exemplary embodiment of the present invention. In Fig. 6, a schematic view is prepared such that a roughly-determined shape of flexible substrate is displayed in advance on display unit 8 if there is any restriction in the shape of flexible substrate. In this schematic view, a designer inputs, using input unit 7, only characteristic numerical dimensions required as 3D shape dimensions. As a result, a chance of breaking the restriction can be suppressed, and also a manhour for inputting the 3D shape can be reduced.

If a flexible substrate is used in an electronic device such as folding mobile phone, the flexible substrate is assumed to be bent frequently by opening and closing the casing of mobile phone. Therefore, it is important to consider mechanical characteristics, i.e., mechanical strength, of flexible substrate in addition to the electrical characteristics in the design. Conventionally, in designing these types of electronic devices, whether electrical characteristics fulfill target values are first examined. Then, after electrical characteristics become satisfactory, mechanical characteristics including the maximum stress and bending destruction strength are evaluated. If the target mechanical characteristics are not fulfilled, a design of flexible substrate is changed, and a process starts, in general, from checking electrical characteristics again. However, in this conventional design process, an engineer for evaluating electrical characteristics and an engineer for evaluating mechanical characteristics are often different, resulting in a long design period.

Therefore, information related to mechanical characteristics, such as allowable deformation level, is stored in a library of flexible substrates in database prepared in advance, in addition to 3D shapes and electrical characteristics. By comparing this data in the library and design information on flexible substrate, simulation of electrical characteristics and whether or not mechanical characteristics achieve target values can be instantaneously evaluated at the same time.

In addition to characteristic calculator 11, an output unit for outputting a file on electrical characteristics calculated by characteristic calculator 11 in a predetermined format may be provided. The system may also include a determination unit for evaluating whether or not the 3D information input to input unit 7 exceeds an allowable deformation level, and an alarm generator for generating an alarm when the 3D shape information exceeds the allowable deformation level. If this library generating system has a function to automatically compare allowable mechanical characteristics and mechanical characteristics of designed flexible substrate, and automatically generate an alarm when exceeding the allowable level, designer's overlook can also be prevented for further effective simulation.

### INDUSTIRAL APPLICABILITY

A library for simulating electronic circuits of flexible substrates of the present invention and the library generating system enable highspeed simulation of electronic devices employing flexible substrates. This increases the design efficiency Accordingly, the present invention is effectively applicable to industrial fields as a method of inexpensively designing electronic devices.

## Claims

1. A library for electronic circuit simulation, the library storing information on an electrical characteristic and information on a three-dimensional shape of a flexible substrate, the electrical characteristic being changed in response to a change in the three-dimensional shape.

2. The library for electronic circuit simulation of claim 1, wherein the electrical characteristic is expressed by a relational expression using a value of an electrical circuit element, the value being a parameter for a dimension of the three-dimensional shape of the flexible substrate as.

3. The library for electronic circuit simulation of claim 1, wherein the electrical characteristic is expressed by a relational expression using a value of S-parameter, the value being a parameter for a dimension of the three-dimensional shape of the flexible substrate.

4. The library for electronic circuit simulation of claim 1, further storing information on an allowable deformation level of the flexible substrate.

5. A library generating system comprising:
an input unit for inputting information on arbitrary three-dimensional shape of a flexible substrate;
a dimension extractor for extracting dimensional information on a characteristic three-dimensional shape for determining an electrical characteristic of the flexible substrate, the dimensional information being extracted from the information on three-dimensional shape input to the input unit; and
a characteristic calculator for calculating the electrical characteristic of the flexible substrate based on the dimensional information extracted by the dimension extractor.

6. A library generating system comprising:
an input unit for inputting a characteristic three-dimensional shape information in information on three-dimensional shape of a flexible substrate; and
a characteristic calculator for calculating an electrical characteristic of the flexible substrate based on the characteristic three-dimensional shape information input to the input unit.

7. The library generating system of one of claims 5 and 6, further comprising a display unit for displaying a schematic view of a characteristic three-dimensional shape of the flexible substrate.

8. The library generating system of one of claims 5 and 6, further comprising an output unit for outputting a file on the electrical characteristic calculated by the characteristic calculator, the file being created in a predetermined format.

9. The library generating system of one of claims 5 and 6, further comprising:
a determination unit for determining whether or not the information on three-dimensional shape input to the input unit exceeds an allowable deformation level; and
an alarm generator for generating an alarm when the information on three-dimensional shape exceeds the allowable deformation level.

10. A recording medium storing:
information on an electrical characteristic of a flexible substrate;
information on three-dimensional shape; and
a library for electronic circuit simulation in which the electrical characteristic changes in response to a change in the three-dimensional shape.
